# EUROPEAN PATENT SPECIFICATION

(11) **EP 3 662 517 B1**
(45) Date of publication and mention of the grant of the patent: **24.03.2021**
(21) Application number: 18750089.7
(22) Date of filing: 31.07.2018
(51) Int. Cl.: H01L 33/44, H01L 33/50, H01L 33/64

(54) **LIGHT EMITTING DEVICE AND METHOD OF MANUFACTURING THEREOF**
LICHTEMITTIERENDES BAUELEMENT UND VERFAHREN ZU DESSEN HERSTELLUNG
DISPOSITIF ÉLECTROLUMINESCENT ET SON PROCÉDÉ DE FABRICATION

(30) Priority: 03.08.2017 US 201715668173; 19.01.2018 EP 18152555
(43) Date of publication of application: 10.06.2020
(73) Proprietor: Lumileds LLC, San Jose, CA 95131 (US)
(72) Inventor: SHIMIZU, Ken T., San Jose California 95131 (US); MASUI, Hisashi, San Jose California 95131 (US); ROITMAN, Daniel B., San Jose California 95131 (US)
(74) Representative: ter Heegde, Paul Gerard Michel
(86) International application number: PCT/US2018/044484
(87) International publication number: WO 2019/027952

(56) References cited:
- WO-A1-2007/144809
- WO-A1-2016/200739
- US-A1- 2008 137 692

## Description

### CROSS REFERENCE TO RELATED APPLICATIONS

This application claims the benefit of U.S. Patent Application No. 15/668,173 filed on August 3, 2017, and EP Patent Application No. 18152555.1 filed on January 19, 2018.

### BACKGROUND

This disclosure relates to a method of manufacturing of a Light Emitting Device that utilizes Atomic Layer Deposition (ALD) to attach a light converting plate to a light emitting diode (LED).

Commonly, in the manufacturing of Light Emitting Device, LED phosphors are deposited over active light emitters in a powder or liquid suspension. To improve phosphor uniformity and simplify wafer, chip scale, or flip chip manufacture, phosphors distributed in a light transparent ceramic have also been developed. Such ceramics can be formed as plates (or platelets) with a controlled amount of phosphor powder being placed in a mold and heated under pressure to sinter the grains together. The platelet can be made very smooth on all surfaces, suitable for attachment.

One example of a ceramic platelet is Lumiramic™. Lumiramic is a phosphor platelet formed from polycrystalline ceramic plate of Ce (III) doped yttrium gadolinium aluminum garnet (Y,GdAG:Ce). The technical properties of Lumiramic are described in "Lumiramic: a new phosphor technology for high performance solid state light sources" (Bechtel, Helmut, Peter Schmidt, Wolfgang Busselt, and Baby S. Schreinemacher. "Lumiramic: A New Phosphor Technology for High Performance Solid State Light Sources." Eighth International Conference on Solid State Lighting (2008): n. pag. Online).

In some applications, Lumiramic plates can be combined with a blue LED to produce white light in the range of 5000 K correlated color temperature. In one automotive application, a Lumiramic platelet is glued to a blue LED using a silicone polymer glue that allows for heat conduction from the phosphor layer into the LED and heat sink as well as providing optical coupling of blue light into the Lumiramic plate to form white light. In other applications, a light emitting element is bonded to the Lumiramic plate using a surface activated bonding technique that relies on sputter etching with ion beams or plasma on a bonding surface of a light emitting element.

A bonding technique that does not require adhesives is atomic layer deposition (ALD). Atomic Layer Deposition (ALD) is a process in which a thin film deposition method in which a film is grown on a substrate by exposing its surface to alternate precursor gases. Methods for performing ALD are known in the art and for example are taught in "Atomic layer deposition (ALD): from precursors to thin film structures" (Leskeia, Markku, and Mikko Ritala. "Atomic Layer Deposition (ALD): From Precursors to Thin Film Structures." Thin Solid Films 409.1 (2002): 138-46. Print.).

### SUMMARY

A method of manufacturing of a Light Emitting Device that has increased reliability and efficiency. Specifically, the disclosed methods use Atomic layer deposition to improve the thermal conductivity between the ceramic plate and the LED, decrease the amount of organic contamination, and increase the efficiency of the optical output of the Light Emitting Device.

The reduction in organic contamination, and the increase in the efficiency may be particularly useful with Thin-Film side coat LED architectures. For example, World Intellectual Property Organization Publication 2017023502 A1 to Masui et al. describes an example of a LED based on a Thin-Film side coat LED architecture that may benefit from the present disclosed method of manufacturing of a Light Emitting Device

The present invention discloses a light emitting device according to claim 1 and a method of manufacturing thereof according to claim 8. Further embodiments are disclosed in the dependent claims.

### BRIEF DESCRIPTION OF THE DRAWINGS

A more detailed understanding may be had from the following description, given by way of example in conjunction with the accompanying drawings, wherein like reference numerals in the figures indicate like elements, and wherein:
FIG. 1 depicts a Light Emitting Device made using the prior art methods.
FIG. 2 depicts a process flow map of an embodiment of the invention.
FIG. 3A depicts a Light Emitting Device in the process of being formed by an embodiment of the invention.
FIG. 3B depicts a Light Emitting Device in the process of being formed by an embodiment of the invention.
FIG. 3C depicts a Light Emitting Device in the process of being formed by an embodiment of the invention.
FIG. 4A depicts an example adhesive location and pattern.
FIG. 4B depicts an example adhesive location and pattern.
FIG. 4C depicts an example adhesive location and pattern.
FIG. 4D depicts an example adhesive location and pattern.
FIG. 5 depicts a process flow map of a second embodiment of the invention.
FIG. 6A depicts a Light Emitting Device in the process of being formed by the second embodiment of the invention.
FIG. 6B depicts a Light Emitting Device in the process of being formed by the second embodiment of the invention.

### DETAILED DESCRIPTION

Examples of different light emitting diode ("LED") implementations will be described more fully hereinafter with reference to the accompanying drawings. These examples are not mutually exclusive, and features found in one example can be combined with features found in one or more other examples to achieve additional implementations. Accordingly, it will be understood that the examples shown in the accompanying drawings are provided for illustrative purposes only and they are not intended to limit the disclosure in any way. Like numbers refer to like elements throughout.

It will be understood that, although the terms first, second, etc. may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes any and all combinations of one or more of the associated listed items.

It will be understood that when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present. It will also be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. It will be understood that these terms are intended to encompass different orientations of the element in addition to any orientation depicted in the figures.

Relative terms such as "below" or "above" or "upper" or "lower" or "horizontal" or "vertical" may be used herein to describe a relationship of one element, layer or region to another element, layer or region as illustrated in the figures. It will be understood that these terms are intended to encompass different orientations of the device in addition to the orientation depicted in the figures.

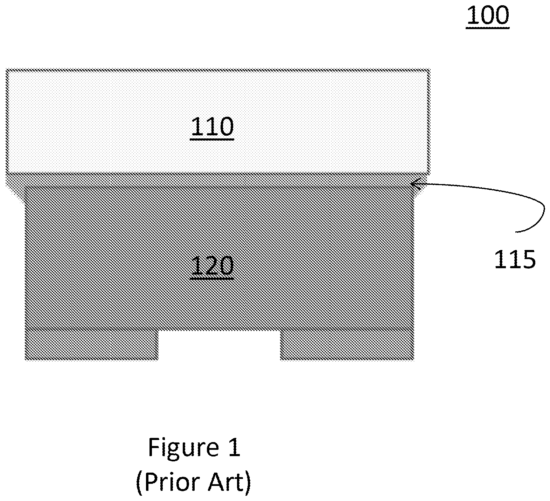

Figure 1 depicts a light emitting device 100 formed using a polymer glue layer 115 bonded between a plate 110 and light emitting diode 120. The polymer glue layer 115 is formed by applying a polymer glue layer (such as a Polydimethylsiloxane based silicone) to either the plate 110 or the light emitting diode 120 and then squeezing the plate 110 and the light emitting diode 120 together. The squeezing of polymer glue between the plate 110 and the light emitting diode 120 often results in the polymer glue leaking out on to the sidewalls of the plate 110 or the light emitting diode 120. The leaking polymer glue adversely affects the optical efficiency of the light emitting device 100. The adverse effects are particularly acute in Thin-Film side coat LED architectures where dielectric broadband mirrors (DBMs) are utilized.

In addition, the inclusion of the polymer glue layer between the plate 110 and light emitting diode 120 impairs the performance and the reliability of the light emitting device 100. For example, the polymer glue used in forming the polymer glue layer 115 is prone to photo-thermal degradation because the polymer glue may either contribute to or is sensitive to organic contamination in the light emitting device 100. In addition, Polymer glues are also poor thermal conductors and typically have a thermal conductivity of approximately 0.2 W/mK. Accordingly, the polymer glue layer 115 is unable to efficiently transfer heat generated by the light emitting diode 120 to the plate 110. Further, the polymer glue has a low refraction index (RI) (of approximately 1.42-1.54) as compared to the refraction index of the plate 110 (RI 1.8) and the light emitting diode 120 (RI 1.8∼2.5 depending on LED die architecture). The low refractive index of the polymer glue layer 115 results in less light being transferred from the light emitting diode 120 to the plate 110 which translates to a light emitting device 100 with lower efficiency.

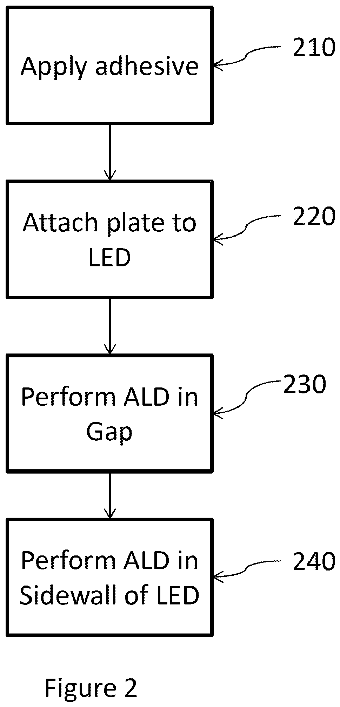

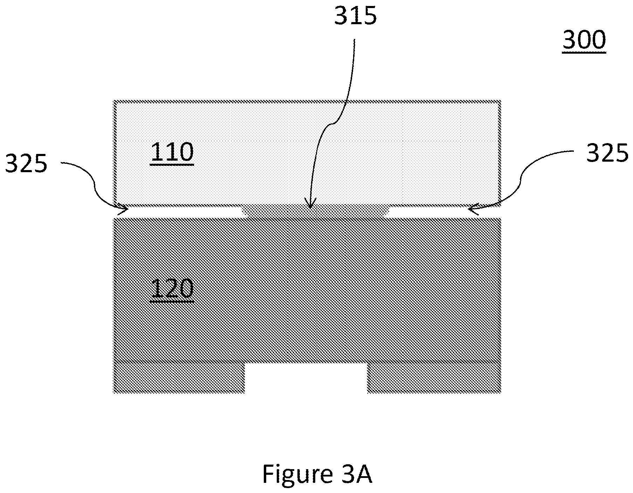

Figure 2 depicts a process flow diagram of an embodiment of the invention for creating light emitting device 300 (shown in Figs. 3A-3C). In step 210, a small amount of adhesive 315 is applied to either the plate 110 or light emitting diode 120. The small amount of adhesive 315 has an area that is much smaller than the surface area of the surface area of the plate 110 or light emitting diode 120. In step 220, the plate 110 and the light emitting diode 120 are attached using the small amount of adhesive 315. Once attached, the plate 110 and light emitting diode 120 are separated by a distance of approximately 1 µm. When the plate 110 and the light emitting diode 120 are attached, a Gap 325 is formed between the plate 110 and the light emitting diode 120 in areas where the adhesive 315 is not applied. Then in step 230, ALD of a transparent material 335 is performed to fill the gap 325. Additionally, in some embodiments, ALD of the transparent material may be performed on the sidewall of the light emitting diode 120 in step 240.

Figure 3A is a graphic depiction of the light emitting device 300 after the completion of step 220. Specifically, Fig. 3A shows the plate 110 connected to the light emitting diode 120 by the small amount of adhesive 315. The connection of plate 110 to the light emitting diode 120 by the small amount of adhesive 315 results in the formation of gaps 325. In some embodiments, the adhesive 315 may be silicone or sol-gel glue. In other embodiments, the adhesive 315 may be a low-melting point glass or transparent adhesive.

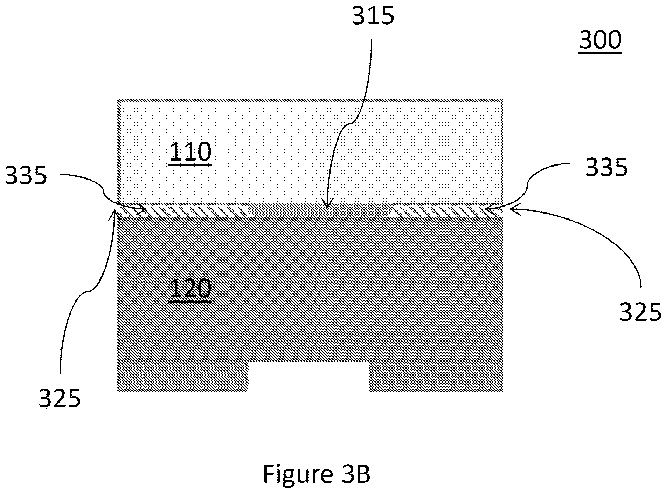

The light emitting device 300 after the completion of step 230 is depicted in Fig. 3B. Fig. 3B shows the transparent material 335 that has been applied by ALD to fill gap 325. By using ALD to fill the gap 325, flatness, irregularities or slight curvature in either the plate 110 or the light emitting diode 120 can be compensated for. In some embodiments, the transparent material 335 may be Alumina (A1203), Niobium oxide (Nb2O5), Zirconia (Zr02), or other high index dielectrics.

In many embodiments, the refraction index of the transparent material 335 is selected to match the index of refraction of the light emitting diode 120. Selecting a transparent material 335 that has a matched index of refraction to light emitting diode 120 may be desirable because the light from the LED can typically be trapped due to total internal reflection from the higher index media entering into a lower index media. Since there is always a finite probability of light absorption in the LED structure, this light trapping results in light output efficiency loss. By matching the refractive index, this loss mechanism is reduced or eliminated.

The ALD coated dielectric may also have a higher thermal conductivity (∼3 W/mK) compared to silicone polymers. The thermal properties of ALD coated dielectrics are discussed in "High Temperature Thermal Conductivity of Amorphous Al2O3 Thin Films Grown by Low Temperature ALD" (Cappella, Andrea, Jean-Luc Battaglia, Vincent Schick, Andrzej Kusiak, Alessio Lamperti, Claudia Wiemer, and Bruno Hay. "High Temperature Thermal Conductivity of Amorphous A1203Thin Films Grown by Low Temperature ALD." Advanced Engineering Materials 15.11 (2013): 1046-050. Print.). Using a ALD coated dielectric with a higher thermal conductivity, may be desirable because heat is generated in the Lumiramic layer and the most efficient path for heat dissipation occurs through the bonding layer into the diode device. All phosphor materials show thermal quenching or loss in efficiency at high temperatures at the higher temperature and higher flux intensities. Therefore, the lowering temperature of the Lumiramic or phosphor layer results in improved light output for the white LED.

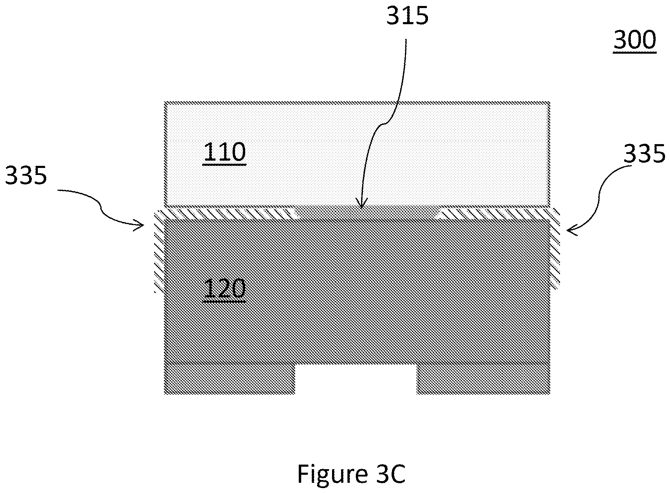

Figure 3C depicts the light emitting device 300 after the completion of step 240. In some embodiments, step 240 may be omitted or performed concurrently with step 230. Fig. 3C shows the transparent material 335 deposited on the sidewall of the light emitting diode 120. Sidewall covering with a reflective surface is important to maximize the color uniformity of the light source and to help direct the light in the forward direction. High brightness LEDs typically require this color uniformity and directionality in applications such as flash LEDs or automotive headlight LEDs.

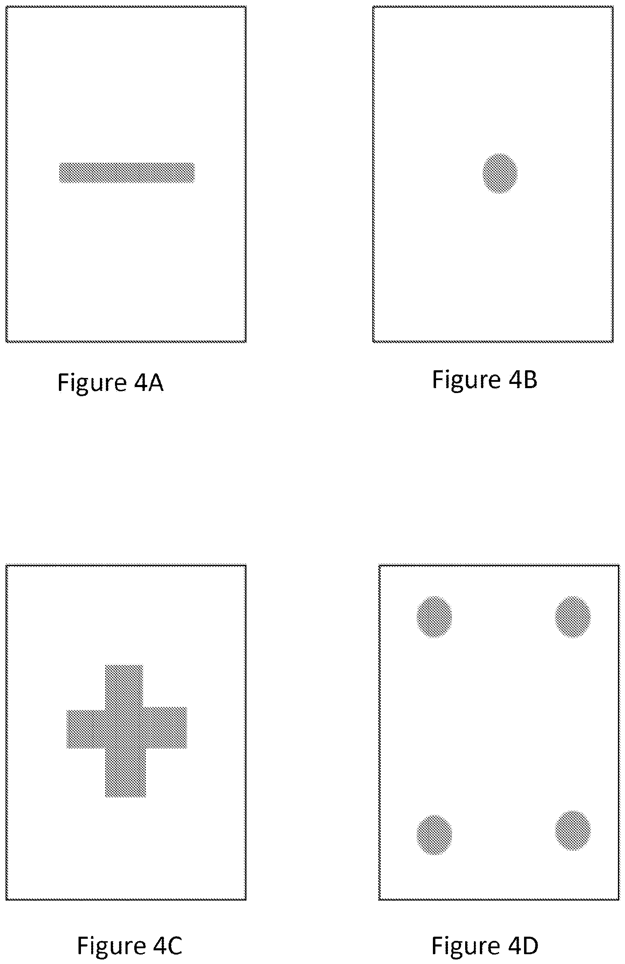

Figures 4A, 4B, 4C and 4D depict different patterns and locations where the adhesive 315 may be applied to either plate 110 or the light emitting diode 120. The particular pattern and location to apply the adhesive 315 may be selected in order to minimize the possibility that the ALD process does not completely fill the gap 325. Closed patterns with separate interior area (such as donut "holes") are not preferred, since ALD would not occur in the interior areas.

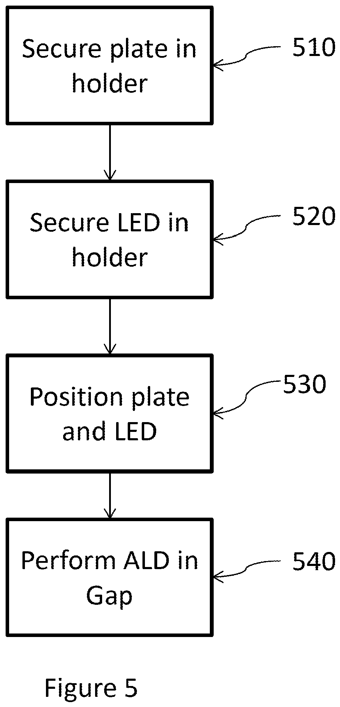

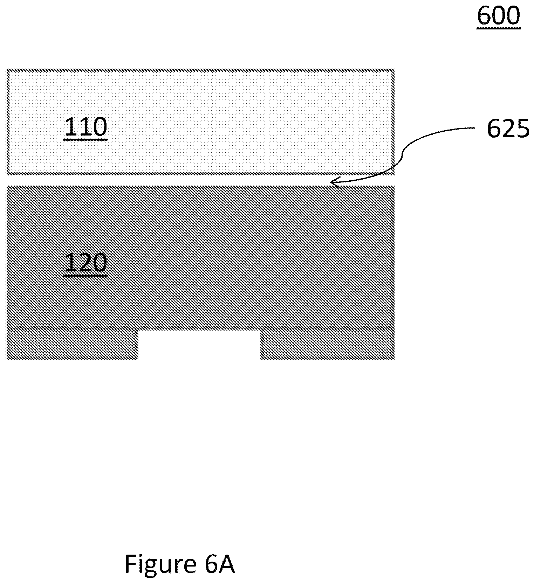

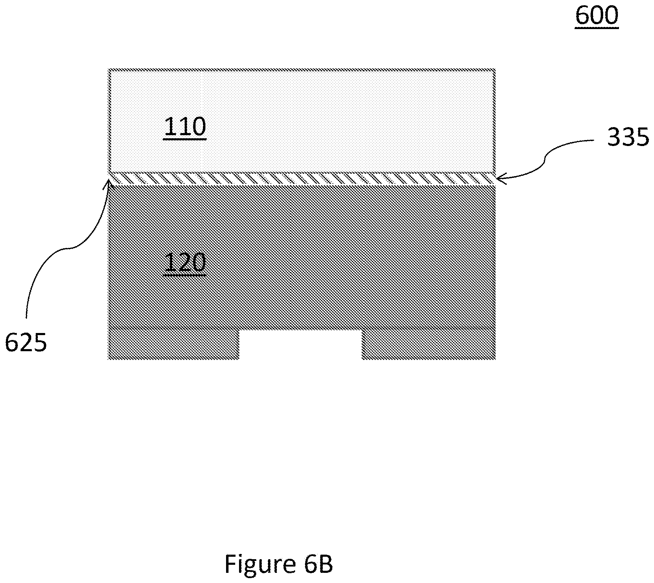

Figure 5 depicts a process map for an alternate embodiment of the invention. In this embodiment, the plate 110 is secured in a mechanical holder (step 510) and the light emitting diode 120 is secured in a mechanical holder (step 520). Then, the plate 110 and light emitting diode 120 are positioned to form gap 625 (shown in Figs. 6A and 6B). Gap 625 has a thickness of approximately 1 µm (step 530). Then, in step 540, ALD of a transparent material 335 is performed to fill the gap 625.

The light emitting device 600, after the completion of step 530, is depicted in Fig. 6A. Fig. 6B shows the light emitting device 600 after the ALD of the transparent material 335 is performed to fill the gap 625 in step 540.

In some embodiments, the plate 110 may be a ceramic phosphor plate such as a Lumiramic or a phosphor filled platelet made in a glass or silicone matrix. In some embodiments, the light emitting diode 120 may be a vertical thin film or a thin-film flip chip, or a CSP flip-chip based LED.

Although features and elements are described above in particular combinations, one of ordinary skill in the art will appreciate that each feature or element can be used alone or in any combination with the other features and elements. In addition, the methods described herein may be implemented in a computer program, software, or firmware incorporated in a computer-readable medium for execution by a computer or processor. Examples of computer-readable media include electronic signals (transmitted over wired or wireless connections) and computer-readable storage media. Examples of computer-readable storage media include, but are not limited to, a read only memory (ROM), a random access memory (RAM), a register, cache memory, semiconductor memory devices, magnetic media such as internal hard disks and removable disks, magneto-optical media, and optical media such as CD-ROM disks, and digital versatile disks (DVDs)

The scope of the invention is defined by the appended claims.

## Claims

1. A light emitting device (300) comprising:
a ceramic phosphor plate (110) comprising a light input surface and an oppositely positioned light output surface;
a light emitting diode (120) comprising a light output surface oriented parallel to and adjacent to the ceramic phosphor plate light input surface; and
a layer bonding the ceramic phosphor plate light input surface directly to the light emitting diode light output surface, the layer comprising a transparent material (335) and an adhesive (315),
the adhesive bonded to a portion of the light input surface of ceramic phosphor plate having a smaller surface area than a total surface area of the light input surface of ceramic phosphor plate and bonded to a portion of the light emitting diode light output surface having a surface area smaller than a total surface area of the light emitting diode light output surface, the transparent material bonding at least some portions of the ceramic phosphor plate light input surface and light emitting diode light output surface not bonded by the adhesive.

2. The light emitting device of claim 1, further comprising:
the transparent material on sidewalls of the light emitting diode.

3. The light emitting device of claim 1, wherein the adhesive is silicone or sol-gel glue.

4. The light emitting device of claim 1, wherein the transparent material is Alumina or Al₂O₃.

5. The light emitting device of claim 1, wherein the portion of the ceramic plate includes a plurality of discrete regions.

6. The light emitting device of claim 1, wherein the portion of the ceramic plate has a cross-sectional area substantially in a shape of a cross or a line.

7. The light emitting device of claim 1, wherein the layer has a thickness perpendicular to the ceramic phosphor plate light input surface and the light emitting diode light output surface of about 1 µm.

8. A method of manufacturing a light emitting device (300) comprising:
applying an adhesive (315) to a portion of a light input surface of a ceramic phosphor plate (110) having a smaller surface area than a total surface area of the light input surface of the ceramic phosphor plate, or applying an adhesive to a portion of a light output surface of a light emitting diode having a smaller surface area than a total surface area of the light output surface of the light emitting diode (120);
affixing the ceramic phosphor plate to the light emitting diode using the adhesive leaving a gap between the light output surface of the light emitting diode and the light input surface of the ceramic phosphor plate; and
depositing in the gap a transparent material (335) by atomic layer deposition.

9. The method of claim 8, further comprising:
coating sidewalls of the light emitting diode with the transparent material by atomic layer deposition.

10. The method of claim 8, wherein the transparent material is Alumina or Al₂O₃.

11. The method of claim 8, wherein the portion of the ceramic plate includes a plurality of discrete regions.

12. The method of claim 8, wherein the portion of the ceramic plate has a cross-sectional area substantially in a shape of a cross or a line.

13. The method of claim 8, wherein the gap has a thickness perpendicular to the ceramic phosphor plate light input surface and the light emitting diode light output surface of about 1 µm.

## Patentansprüche

1. Lichtemittierendes Bauelement (300), umfassend:
eine keramische Phosphorplatte (110), umfassend eine Lichteingabefläche und eine gegenüber positionierte Lichtausgabefläche;
eine lichtemittierende Diode (120), umfassend eine Lichtausgabefläche, die parallel ausgerichtet zu und benachbart der Lichteingabefläche der keramischen Phosphorplatte ist; und
eine Schicht, die die Lichteingabefläche der keramischen Phosphorplatte direkt an die Lichtausgabefläche der lichtemittierenden Diode bindet, wobei die Schicht ein transparentes Material (335) und einen Klebstoff (315) umfasst,
wobei der Klebstoff, gebunden an einen Abschnitt der Lichteingabefläche der keramischen Phosphorplatte, einen kleineren Flächenbereich als einen gesamten Flächenbereich der Lichteingabefläche der keramischen Phosphorplatte aufweist, und gebunden an einen Abschnitt der Lichtausgabefläche der lichtemittierenden Diode einen Oberflächenbereich aufweist, der kleiner als ein gesamter Flächenbereich der Lichtausgabefläche der lichtemittierenden Diode ist, wobei das transparente Material mindestens einige Abschnitte der Lichteingabefläche aus keramischer Phosphorplatte und der Lichtausgabefläche der lichtemittierenden Diode bindet, die nicht durch den Klebstoff gebunden ist.

2. Lichtemittierendes Bauelement nach Anspruch 1, weiter umfassend:
das transparente Material auf Seitenwänden der lichtemittierenden Diode.

3. Lichtemittierendes Bauelement nach Anspruch 1, wobei der Klebstoff Silikon oder Sol-Gel-Kleber ist.

4. Lichtemittierendes Bauelement nach Anspruch 1, wobei das transparente Material Aluminiumoxid oder Al₂O₃ ist.

5. Lichtemittierendes Bauelement nach Anspruch 1, wobei der Abschnitt der keramischen Platte eine Vielzahl von disktreten Regionen beinhaltet.

6. Lichtemittierendes Bauelement nach Anspruch 1, wobei der Abschnitt der keramischen Platte einen Querschnittsbereich im Wesentlichen in Form eines Kreuzes oder einer Linie aufweist.

7. Lichtemittierendes Bauelement nach Anspruch 1, wobei die Schicht eine Dicke senkrecht zur Lichteingabefläche der keramischen Phosphorplatte und zur Lichtausgabefläche der lichtemittierenden Diode von ungefähr 1 µm aufweist.

8. Verfahren zur Herstellung eines lichtemittierenden Bauelements (300), umfassend:
Anwenden eines Klebstoffs (315) auf einen Abschnitt einer Lichteingabefläche einer keramischen Phosphorplatte (110) mit einem kleineren Flächenbereich als einem gesamten Flächenbereich der Lichteingabefläche der keramischen Phosphorplatte, oder Anwenden eines Klebstoffs auf einen Abschnitt einer Lichtausgabefläche einer lichtemittierenden Diode mit einem kleineren Flächenbereich als einem gesamten Flächenbereich der Lichtausgabefläche der lichtemittierenden Diode (120);
Befestigen der keramischen Phosphorplatte der lichtemittierenden Diode unter Verwendung des Klebstoffs, wobei ein Zwischenraum zwischen der Lichtausgabefläche der lichtemittierenden Diode und der Lichteingabefläche der keramischen Phosphorplatte gelassen wird; und
Abscheiden im Zwischenraum eines transparenten Materials (335) durch Atomlagenabscheidung.

9. Verfahren nach Anspruch 8, weiter umfassend:
Beschichten der Seitenwände der lichtemittierenden Diode mit dem transparenten Material durch Atomlagenabscheidung.

10. Verfahren nach Anspruch 8, wobei das transparente Material Aluminiumoxid oder Al₂O₃ ist.

11. Verfahren nach Anspruch 8, wobei der Abschnitt der keramischen Platte eine Vielzahl von diskreten Regionen beinhaltet.

12. Verfahren nach Anspruch 8, wobei der Abschnitt der keramischen Platte einen Querschnittsbereich im Wesentlichen in Form eines Kreuzes oder einer Linie aufweist.

13. Verfahren nach Anspruch 8, wobei der Zwischenraum eine Dicke senkrecht zur Lichteingabefläche der keramischen Phosphorplatte und zur Lichtausgabefläche der lichtemittierenden Diode von ungefähr 1 µm aufweist.

## Revendications

1. Dispositif électroluminescent (300) comprenant :
une plaque de luminophore céramique (110) comprenant une surface d'entrée de lumière et une surface de sortie de lumière positionnée de façon opposée ;
une diode électroluminescente (120)
comprenant une surface de sortie de lumière orientée parallèlement et adjacente à la surface d'entrée de lumière de la plaque de luminophore céramique ; et
une couche reliant la surface d'entrée de lumière de la plaque de luminophore céramique directement à la surface de sortie de lumière de la diode électroluminescente, la couche comprenant un matériau transparent (335) et un adhésif (315),
l'adhésif étant lié à une partie de la surface d'entrée de lumière de plaque de luminophore céramique ayant une aire de surface inférieure à une aire de surface totale de la surface d'entrée de lumière de plaque de luminophore céramique et lié à une partie de la surface de sortie de lumière de la diode électroluminescente ayant une aire de surface inférieure à une aire de surface totale de la surface de sortie de lumière de la diode électroluminescente, le matériau transparent liant au moins certaines parties de la surface d'entrée de lumière de la plaque de luminophore céramique et de la surface de sortie de lumière de la diode électroluminescente non liées par l'adhésif.

2. Dispositif électroluminescent selon la revendication 1, comprenant en outre :
le matériau transparent sur des parois latérales de la diode électroluminescente.

3. Dispositif électroluminescent selon la revendication 1, dans lequel l'adhésif est une colle à base de silicone ou sol-gel.

4. Dispositif électroluminescent selon la revendication 1, dans lequel le matériau transparent est l'alumine ou Al₂O₃.

5. Dispositif électroluminescent selon la revendication 1, dans lequel la partie de la plaque de céramique comprend une pluralité de régions discrètes.

6. Dispositif électroluminescent selon la revendication 1, dans lequel la partie de la plaque de céramique a une aire de section transversale sensiblement en forme de croix ou de ligne.

7. Dispositif électroluminescent selon la revendication 1, dans lequel la couche a une épaisseur perpendiculaire à la surface d'entrée de lumière de la plaque de luminophore céramique et à la surface de sortie de lumière de la diode électroluminescente d'environ 1 µm.

8. Procédé de fabrication d'un dispositif électroluminescent (300) comprenant :
l'application d'un adhésif (315) sur une partie d'une surface d'entrée de lumière d'une plaque de luminophore céramique (110) ayant une aire de surface inférieure à une aire de surface totale de la surface d'entrée de lumière de la plaque de luminophore céramique, ou l'application d'un adhésif sur une partie d'une surface de sortie de lumière d'une diode électroluminescente ayant une aire de surface inférieure à une aire de surface totale de la surface de sortie de lumière de la diode électroluminescente (120) ;
la fixation de la plaque de luminophore céramique à la diode électroluminescente au moyen de l'adhésif en laissant un espacement entre la surface de sortie de lumière de la diode électroluminescente et la surface d'entrée de lumière de la plaque de luminophore céramique ; et
le dépôt dans l'espacement d'un matériau transparent (335) par dépôt de couche atomique.

9. Procédé selon la revendication 8, comprenant en outre :
le revêtement de parois latérales de la diode électroluminescente avec le matériau transparent par dépôt de couche atomique.

10. Procédé selon la revendication 8, dans lequel le matériau transparent est l'alumine ou Al₂O₃.

11. Procédé selon la revendication 8, dans lequel la partie de la plaque de céramique comprend une pluralité de régions discrètes.

12. Procédé selon la revendication 8, dans lequel la partie de la plaque de céramique a une aire de section transversale sensiblement en forme de croix ou de ligne.

13. Procédé selon la revendication 8, dans lequel l'espacement a une épaisseur perpendiculaire à la surface d'entrée de lumière de la plaque de luminophore céramique et à la surface de sortie de lumière de la diode électroluminescente d'environ 1 µm.
